# EUROPEAN PATENT SPECIFICATION

(11) **EP 0 295 183 B1**
(45) Date of publication and mention of the grant of the patent: **12.10.1994**
(21) Application number: 88401399.6
(22) Date of filing: 08.06.1988
(51) Int. Cl.: H01L 27/02

(54) **Master slice type semiconductor integrated circuit having sea of gates**
Integrierte-Masterslice-Halbleiterschaltung mit einem Meer von Gates
Circuit intégré semi-conducteur du type à tranche maîtresse comportant une mer de portes

(30) Priority: 08.06.1987 JP 142493/87; 08.06.1987 JP 142499/87
(43) Date of publication of application: 14.12.1988
(73) Proprietor: FUJITSU LIMITED, Kawasaki-shi, Kanagawa 211 (JP)
(72) Inventor: Miura, Daisuke, Yokohama-shi Kanagawa 223 (JP)
(74) Representative: Joly, Jean-Jacques

(56) References cited:
- FR-A- 2 393 427
- JP-A-62 122 419
- PATENT ABSTRACTS OF JAPAN, vol. 7, no. 251 (E-209)[1396], 8th November 1983 ; & JP-A-58 139 446
- PATENT ABSTRACTS OF JAPAN, vol. 9, no. 99 (E-311)[1822], 27th April 1985 ; & JP-A-59 225 615

## Description

### BACKGROUND OF THE INVENTION

The present invention generally relates to master slice type semiconductor integrated circuits, and more particularly to a master slice type semiconductor integrated circuit having a sea of gates.

Generally, in a master slice type semiconductor integrated circuit, a plurality of columns of basic cells are arranged with interconnection (wiring) channels sandwiched therebetween at a central portion of a chip excluding regions of input/output cells. But in the recent master slice type semiconductor integrated circuit having the so-called sea of gates (or channel-less gate array), the basic cells are arranged in the entire central portion of the chip excluding the regions of the input/output cells, and logic unit cells and the interconnection channels are formed on the basic cells. According to this master slice type semiconductor integrated circuit having the sea of gates, it is possible to integrate a large number of gates because the interconnection channels can be reduced to a minimum.

When the integration density of the master slice type semiconductor integrated circuit increases by the use of the sea of gates, the circuit construction generally requires in addition to the logic unit cells random access memories (RAMs), read only memories (ROMs) and the like. For this reason, it is desirable that the master slice type semiconductor integrated circuit having the sea of gates has such a construction that the RAMs, ROMs and the like can be formed with ease from the basic cells in addition to the formation of the logic unit cells.

In the conventional master slice type semiconductor integrated circuit having the sea of gates, the basic cells are basically formed in a complementary metal oxide semiconductor (CMOS) structure for the formation of the logic unit cells. In other words, the basic cells are made of the same number of N-channel MOS transistors and P-channel MOS transistors.

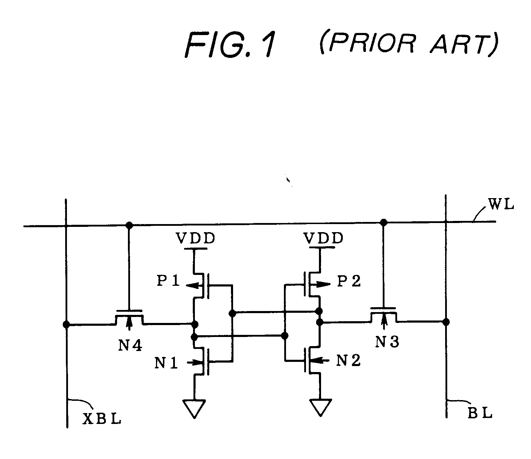

FIG.1 shows an example of the static RAM formed in the conventional master slice type semiconductor integrated circuit having the sea of gates. As shown, a latch circuit is constituted by N-channel MOS transistors N1 and N2 and P-channel MOS transistors P1 and P2, and a transmission gate is constituted by N-channel MOS transistors N3 and N4. WL denotes a word line, and BL and XBL denote bit lines. The numbers of N-channel MOS transistors and P-channel MOS transistors used in the static RAM are not the same. As a result, the utilization efficiency of the basic cells is poor when forming the static RAM in the semiconductor integrated circuit having the sea of gates.

In addition, when forming the ROM in the conventional master slice type semiconductor integrated circuit having the sea of gates, only N-channel MOS transistors are generally used with priority on the read-out speed of the ROM. In this case, only one-half portion of the basic cells, that is, only the N-channel MOS transistors, are used, thereby resulting in a poor utilization efficiency of the basic cells.

On the other hand, when the integration density of the master slice type semiconductor integrated circuit increases by the use of the sea of gates, there is a demand to integrate a programmable logic array (PLA) in the circuit in addition to the logic unit cells. The PLA has a two-level structure comprising ROMs in an AND plane and ROMs in an OR plane, and it is possible to generate various kinds of logic functions by use of a small number of transistors.

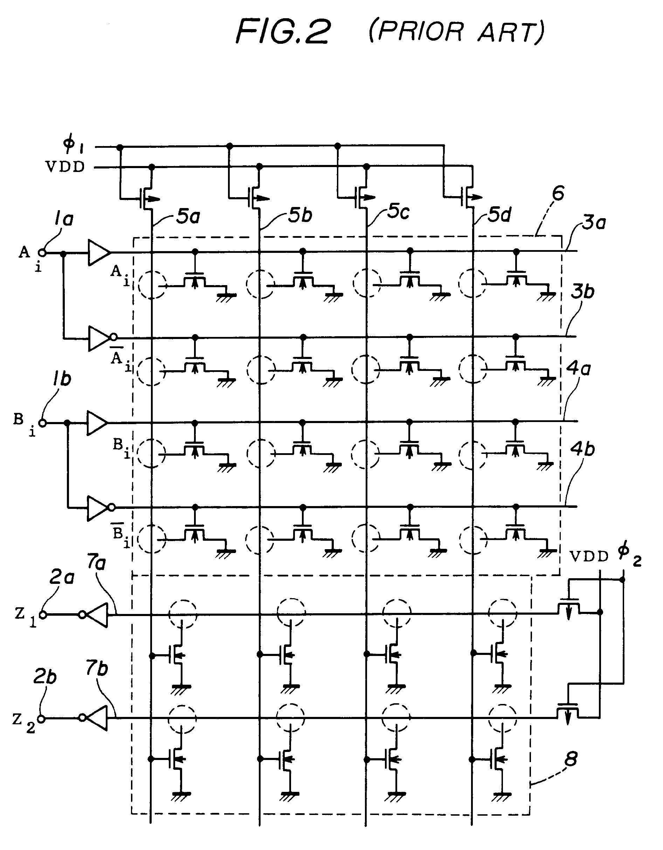

FIG.2 shows an example of the conventional PLA. Input signals Aᵢ and Bᵢ are applied to terminals 1a and 1b. Signals Aᵢ, A̅ᵢ, Bᵢ and B̅ᵢ are supplied to input lines 3a, 3b, 4a and 4b, respectively. N-channel MOS transistors of an AND plane 6 are provided at intersections of the input lines 3a, 3b, 4a and 4b and product term lines 5a, 5b, 5c and 5d. In addition, N-channel MOS transistors of an OR plane 8 are provided at intersections of the product term lines 5a, 5b, 5c and 5d and output lines 7a and 7b. Output signals Z₁ and Z₂ are outputted from terminals 2a and 2b. The programming is carried out by connecting drains of the N-channel MOS transistors of the AND plane 6 to the respective product term lines 5a through 5d and connecting drains of the N-channels MOS transistors of the OR plane 8 to the respective output lines 7a and 7b at positions encircled by phantom lines. V_{DD} denotes a power source voltage, and φ₁ and φ₂ denote clock signals of mutually different phases.

However, the following problems occur when an attempt is made to form the PLA in the conventional master slice type semiconductor integrated circuit.

Firstly, only N-channel MOS transistors are used on the AND plane 6 and the OR plane 8 with priority on the read-out speed, but in the conventional semiconductor integrated circuit having the sea of gates, the basic cells are basically formed in the CMOS structure for the formation of the logic unit cells. In other words, the basic cells are made of the same number of N-channel MOS transistors and P-channel MOS transistors. For this reason, when the PLA is formed by use of only the N-channel MOS transistors, the P-channel MOS transistors of the basic cells will not be used, and the utilization efficiency of the basic cells becomes poor.

Secondly, in the conventional master slice type semiconductor integrated circuit, a plurality of transistors are arranged in an X-direction (column direction) within the basic cell, for example, and gates thereof are connected in common. On the other hand, in the PLA, gates of the plurality of transistors arranged in the column direction on the AND plane 6 are connected in common, and gates of the plurality of transistors arranged in a row direction on the OR plane 8 are connected in common. Accordingly, when the input lines 3a through 4b are provided in the X-direction (column direction) of the basic cells of the semiconductor integrated circuit and the product term lines 5a through 5d are provided in a Y-direction (row direction) of the basic cells, only a single transistor of the basic cell can be used on the OR plane 8, thereby deteriorating the utilization efficiency of the basic cells.

For these reasons, the PLA is not formed in the conventional master slice type semiconductor integrated circuit.

### SUMMARY OF THE INVENTION

Accordingly, it is a general object of the present invention to provide a novel and useful master slice type semiconductor integrated circuit having a sea of gates, in which the problems described heretofore are eliminated and the demands are satisfied.

Another and more specific object of the present invention is to provide a master slice type semiconductor integrated circuit which enables high utilization efficiency of basic cells when forming logic unit cells, RAMs, ROMs and the like in the semiconductor integrated circuit.

Still another object of the present invention is to provide a master slice type semiconductor integrated circuit which enables high utilization efficiency of basic cells when forming a PLA in the semiconductor integrated circuit.

Accordingly, the present invention relates to a master slice type semiconductor integrated circuit comprising a semiconductor chip, input/output cells arranged in a peripheral portion of the semiconductor chip, and basic cells arranged in a central portion of the semiconductor chip,
each of said basic cells including a first portion containing complementary MOSFETs in the form of pairs of first and second N-channel MOSFETs and first and second P-channel MOSFETs, the P-channel MOSFETs of said pairs comprising first and second P-type regions spaced from each other in a first, column, direction by an N-type channel region oriented in a second direction perpendicular to said first direction insulatingly overlaid by a conductive gate electrode; the N-channel MOSFETs of said pairs comprising first and second N-type regions spaced from each other in said first column direction by an P-type channel region oriented in said second direction insulatingly overlaid by a conductive gate electrode; said first regions, second regions, channel regions, and gate electrodes of the N-channel MOSFETs of said pairs being located adjacent said first regions, second regions, channel regions, and gate electrodes of the P-channel MOSFETs of said pairs, respectively, in said second direction; each of said basic cells further including a second portion containing third and fourth MOSFETs of the NMOS type;
said second-portion of each of said basic cells being located adjacent said first portion of a respective one of said basic cells in a said second direction; said second portion of each of said basic cells containing at least one MOSFET comprising first and second N-type regions, spaced from each other by a P-type channel region insulatingly overlaid by a conductive gate electrode.

A semiconductor integrated circuit of this kind is described in JP-A-58 139 446, the object of which is only to form a single port memory; however, the cell layout thereof is not particularly efficient.

Reference can also be made to FR-A-2 393 427 which relates to an integrated circuit comprising basic cells the pattern of which can take four positions by rotation of 90° or 180°.

The circuit of the present invention is further characterized in that said first and second N-type regions are spaced from each other in said first direction; and that the conductive gate electrode of said at least one MOSFET is offset in said first column direction from the conductive gates of any of the MOSFETs of said first portion containing complementary MOSFETs to allow one of said first or second N-type regions to be connected to one of said gate electrodes in said first portion directly by an interconnection aligned in said second direction. According to the circuit of the present invention, the utilization efficiency of the basic cell is extremely high when forming the logic unit cell, the RAM, the ROM and the like. There is virtually no unused or wasted portion of the basic cell, thereby greatly improving the integration density of the semiconductor integrated circuit.

A circuit according to the invention can be arranged to be operable as a single port static random access memory, a dual port random access memory, a read only memory or a programmable logic array memory, as specified in claims 12 to 15, respectively. As a result, the field of application of the master slice type semiconductor integrated circuit is considerably expanded.

Other objects and further features of the present invention will be apparent from the following detailed description when read in conjunction with the accompanying drawings.

### BRIEF DESCRIPTION OF THE DRAWINGS

FIG.1 is a circuit diagram showing an example of the static RAM formed in the conventional master slice type semiconductor integrated circuit having the sea of gates;
FIG.2 is a circuit diagram showing an example of the PLA;
FIG.3 is a plan view generally showing an embodiment of the master slice type semiconductor integrated circuit according to the present invention;
FIGS.4 and 5 are plan views showing an embodiment of the basic cells of the embodiment on an enlarged scale;
FIGS.6A through 6E are cross sectional views showing the basic cells along lines VIA-VIA, VIB-VIB, VIC-VIC, VID-VID and VIE-VIE in FIG.5, respectively;
FIGS.7A and 7B are circuit diagrams respectively showing equivalent circuits of a CMOS forming part of the basic cells and mutually adjacent NMOS forming parts of the basic cells;
FIG.8A schematically shows a row of basic cells;
FIG.8B schematically shows logic unit cells formed by use of the basic cells shown in FIG.8A;
FIG.8C schematically shows a RAM formed by use of the basic cells shown in FIG.8A;
FIG.8D schematically shows a ROM formed by use of the basic cells shown in FIG.8A;
FIGS.9A and 9B respectively show arrangements of devices which may use the same interconnection;
FIGS.10A and 10B are a wiring diagram and a circuit diagram respectively showing 1-port static RAM cells using the basic cells of the present embodiment;
FIGS.11A and 11B are a schematic diagram and a circuit diagram respectively showing a portion of the 1-port static RAM cells shown in FIGS.10A and 10B;
FIGS.12A and 12B are a wiring diagram and a circuit diagram of 2-port static RAM cells using the basic cells of the present embodiment;
FIGS.13A and 13B are a schematic diagram and a circuit diagram respectively showing a portion of the 2-port static RAM cells shown in FIGS.12A and 12B;
FIGS.14A and 14B are a wiring diagram and a circuit diagram of ROM cells using the basic cells of the present embodiment;
FIG.15 is a schematic diagram showing a portion of the ROM cells shown in FIGS.14A and 14B;
FIGS.16 and 17 are a wiring diagram and a circuit diagram respectively showing a first embodiment of the PLA;
FIG.18 is a schematic diagram showing a portion of the PLA shown in FIGS.17 and 18;
FIG.19 is a circuit diagram showing a second embodiment of the PLA;
FIG.20 is a circuit diagram showing a third embodiment of the PLA; and
FIGS.21A and 21B are a schematic diagram and a circuit diagram showing a portion of a fourth embodiment of the PLA.

### DETAILED DESCRIPTION

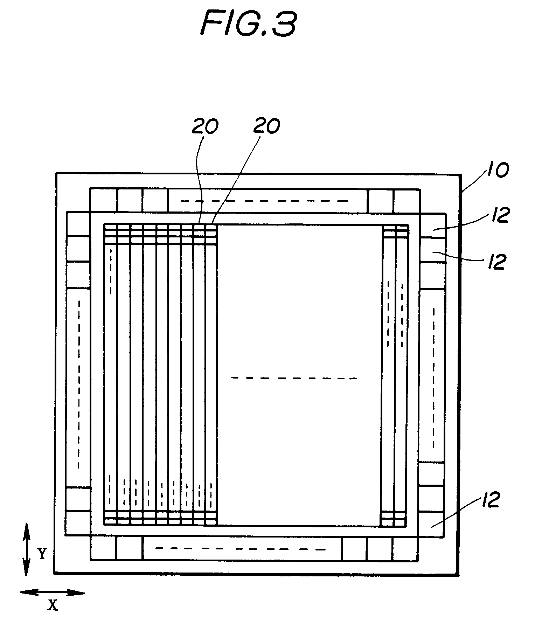

FIG.3 generally shows an embodiment of the master slice type semiconductor integrated circuit according to the present invention. A semiconductor chip 10 comprises a plurality of input/output cells 12 provided in a peripheral portion of the chip 10 and a plurality of basic cells 20 provided in a central portion of the chip 10.

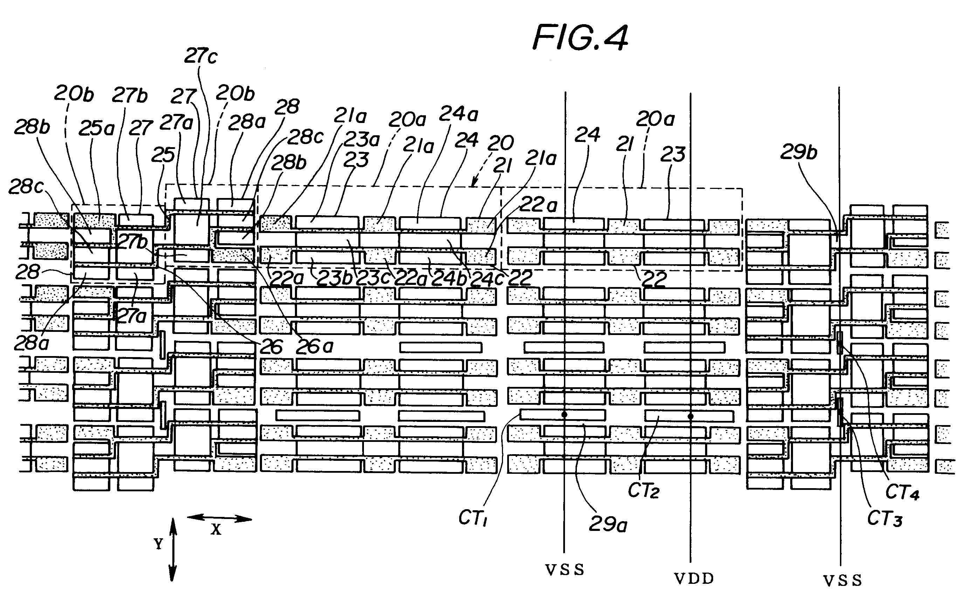

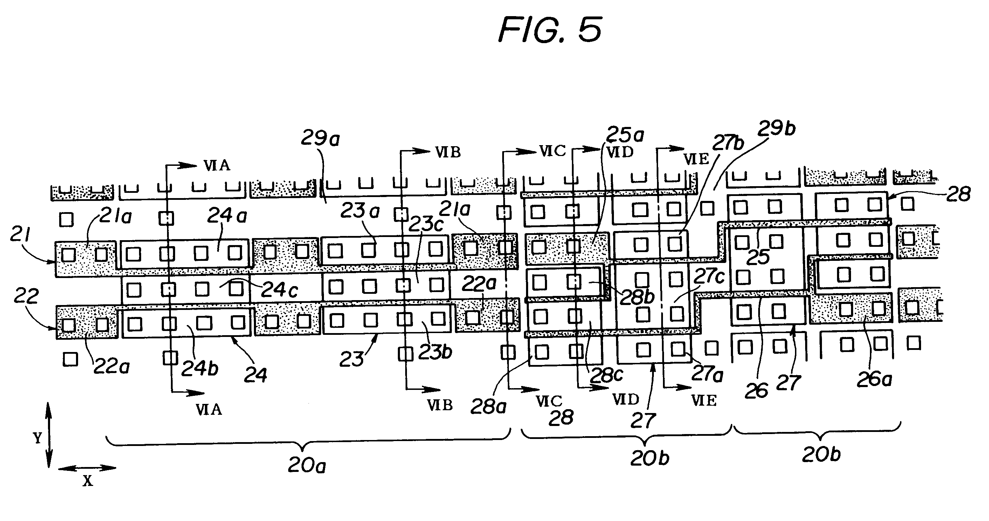

FIGS.4 and 5 show an embodiment of the basic cells of the embodiment on an enlarged scale. FIGS.4 and 5 shows the so-called master on which no aluminum interconnection (wiring) has been formed. In the master slice type semiconductor integrated circuit, the master which is prepared is already formed with gate electrodes, and the aluminum interconnection is formed on an upper layer of the master depending on the needs of the user. In FIG.4, V_{DD} and V_{SS} denote first and second power source voltages. In the present embodiment, V_{SS} denotes the ground voltage.

In FIGS.4 and 5, the basic cell 20 comprises a CMOS forming part 20a and an N-channel MOS (hereinafter simply referred to as an NMOS) forming part 20b. The CMOS forming part 20a is constituted by gate electrodes 21 and 22 indicated by a shading, a P-channel MOS (hereinafter simply referred to as a PMOS) part 23, and an NMOS part 24. The PMOS part 23 comprises P-channel portions 23a, 23b and 23c, and two PMOS transistors are formed using the P-channel portion 23c in common. The NMOS part 24 comprises N-channel portions 24a, 24b and 24c, and two NMOS transistors are formed using the N-channel portion 24c in common. The gate electrodes 21 and 22 respectively have wide portions 21a and 22a for connecting the interconnection on the upper layer in a slicing process.

The NMOS forming part 20b is constituted by gate electrodes 25 and 26 indicated by a shading, and NMOS parts 27 and 28. The NMOS part 27 comprises N-channel portions 27a, 27b and 27c, while the NMOS part 28 comprises N-channel portions 28a, 28b and 28c. Two NMOS transistors are formed in the NMOS part 27 by using the N-channel portion 27c in common, and two NMOS transistors are formed in the NMOS part 28 by using the N-channel portion 28c in common.

The gate electrodes 21, 22, 25 and 26 are made of polysilicon and are formed integrally.

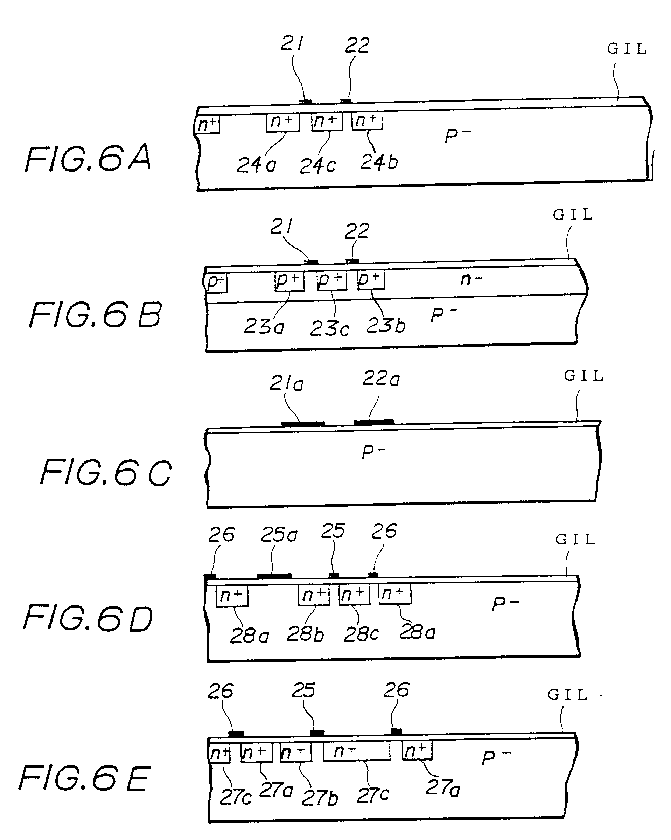

FIGS.6A through 6E are cross sectional views of the basic cell along lines VIA-VIA, VIB-VIB, VIC-VIC, VID-VID and VIE-VIE in FIG.5, respectively. In FIGS.6A through 6E, GIL denotes a gate insulator layer made of silicon dioxide (SiO₂), for example.

The width of the N-channel portion 27c in the Y-direction is two times that of the N-channel portion 28c, and two connecting portions can be provided both in the X and Y directions. When there is a need to connect the NMOS part 28 and the CMOS part 20a by a first layer aluminum interconnection and connect the NMOS part 27 and the CMOS part 20a by a second layer aluminum interconnection, for example, it is necessary to have a first connecting portion for connecting the N-channel portion 27c to the first layer aluminum interconnection and a second connecting portion for connecting the first layer aluminum interconnection to the second layer aluminum interconnection in order to connect the N-channel portion 27c to the second layer aluminum interconnection. In this case, when the first and second connecting portions are arranged in the Y-direction, it is possible to provide other interconnections such as bit lines on the remaining connecting portions arranged in the X-direction. In other words, it is possible to reduce the overall width of the basic cell 20 in the X-direction without the need to increase the width of the NMOS part 27 in the X-direction.

The gate electrodes 25 and 26 are constituted by common electrodes which are integral parts of gates of the NMOS forming part 20b of the basic cell 20 which is adjacent on the left of the gate electrodes 25 and 26 in the X-direction. These gate electrodes 25 and 26 are provided with wide portions 25a and 26a, respectively. The two mutually adjacent NMOS forming parts 20b are point symmetrical about a point on a boundary between the two in a state where the two are shifted in the Y-direction.

The CMOS forming parts 20a of the basic cells 20 adjacent to each other in the X-direction are line symmetrical about a boundary line between the two.

Thus, a plurality of the basic cells 20 are arranged in the X and Y directions in the entire central portion of the chip 10 as shown in FIG.3, excluding the regions of the input/output cells 12.

A portion 29a is formed between the basic cells 20 adjacent to each other in the Y-direction, and a portion 29b is formed between the NMOS forming parts 20b (of the basic cells 20) adjacent to each other in the X-direction. The portions 29a and 29b are provided for making contacts to a substrate of the chip 10.

For convenience' sake, FIG.4 only shows some of the contacts provided in the portions 29a and 29b. A contact CT₁ is provided in the portion 29a for supplying the power source voltage V_{SS} to the NMOS transistors in the CMOS forming part 20a. Similarly, a contact CT₂ is provided in the portion 29a for supplying the power source voltage V_{DD} to the PMOS transistors in the CMOS forming part 20a. Contacts CT₃ and CT₄ are provided in the portion 29b for supplying the power source voltage V_{SS} to the transistors of the NMOS forming part 20b. To simplify the figure, the interconnections for supplying the power source voltages V_{SS} and V_{DD} are illustrated as lines.

In FIG.5, rectangular marks indicate positions where a connection can be made with the aluminum interconnection.

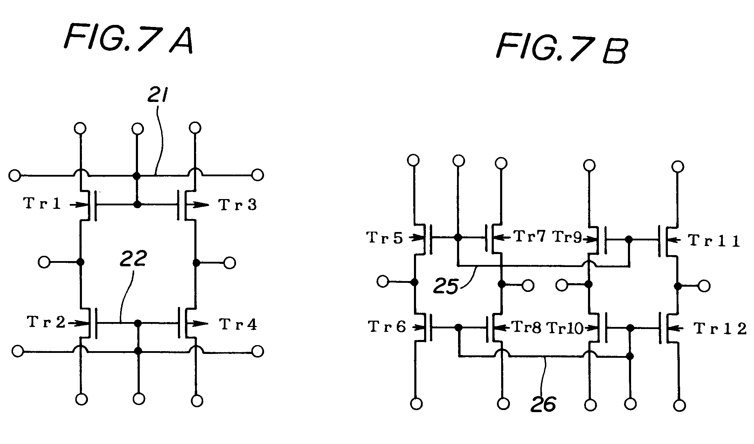

FIGS.7A and 7B show equivalent circuits of parts of the basic cell shown in FIG.5. FIG.7A shows an equivalent circuit of the CMOS forming part 20a. In FIG.7A, transistors Tr1 and Tr2 are NMOS transistors of the NMOS part 24, and transistors Tr3 and Tr4 are PMOS transistors of the PMOS part 23. On the other hand, FIG.7B shows an equivalent circuit of the pair of mutually adjacent NMOS forming parts 20b. In FIG.7B, transistors Tr5, Tr6, Tr11 and Tr12 are NMOS transistors of the NMOS part 28, and transistors Tr7, Tr8, Tr9 and Tr10 are NMOS transistors of the NMOS part 27.

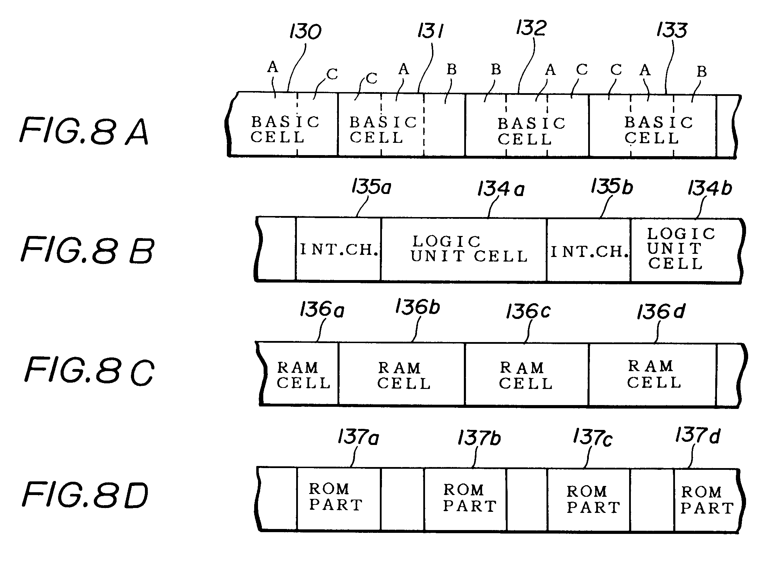

FIG.8A shows a row of basic cells 130, 131, 132 and 133 in the Y-direction. In FIG.8A, A and B respectively indicate the PMOS part 23 and the NMOS part 24 of the CMOS forming part 20a shown in FIG.3, and C indicates the NMOS forming part 20b.

When forming logic unit cells of the CMOS by use of the basic cells 130 through 133, logic unit cells 134a and 134b are formed from the CMOS forming parts A and B as shown in FIG.8B, and the NMOS forming parts C are used as interconnection channels 135a and 135b.

When forming a RAM, RAM cells 136a through 136d are formed from the basic cells 130 through 133, respectively, as shown in FIG.8C.

When forming a ROM, ROM parts 137a through 137d are formed in the NMOS parts B and C as shown in FIG.8D. The ROM parts 137a through 137d have a plurality of cells in each of the NMOS parts B and C, and the CMOS part A is not used.

There is no need to provide the interconnection channels when forming the RAM and the ROM shown in FIGS.8C and 8D.

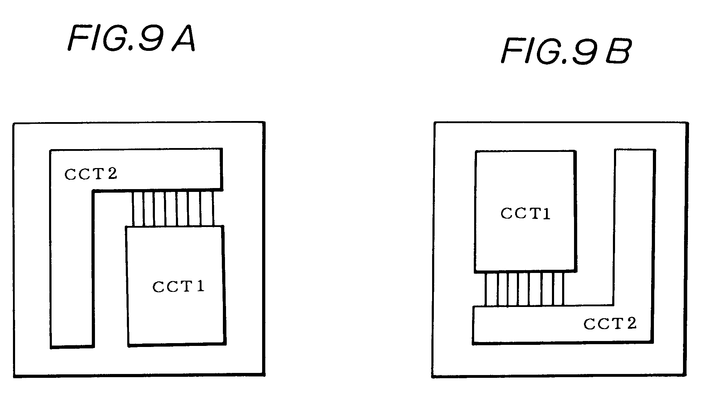

As described before, the two mutually adjacent NMOS forming parts 20b are point symmetrical about the point on the boundary between the two in the state where the two are shifted in the Y-direction, and further, the CMOS forming parts 20a of the basic cells 20 adjacent to each other in the X-direction are line symmetrical about the boundary line between the two. For this reason, when the interconnection is designed automatically in computer aided design (CAD) for a device having an arrangement shown in FIG.9A, the same interconnection can be used for a device having an arrangement shown in FIG.9B, for example, by rotating the interconnection 180°. In FIGS.9A and 9B, CCT₁ and CCT₂ denote circuit parts constituted by the basic cells. Hence, it is unnecessary to re-design the interconnection for the arrangement shown in FIG.9B, and it is easier to meet the user's demands.

In the case of the RAM, for example, the number of terminals becomes extremely large when the number of bits is large, and it would be both time consuming and troublesome to design interconnections for every user's needs. But according to the present embodiment, it is possible to use the same interconnection for arrangements having a certain relationship such as that of FIGS.9A and 9B. In addition, when making a dual port RAM, for example, it is only necessary to design one kind of interconnection for the peripheral circuits such as the address decoder. The interconnection used for the address decoder provided with respect to one of the two ports can be rotated and used for the address decoder provided with respect to the other of the two ports.

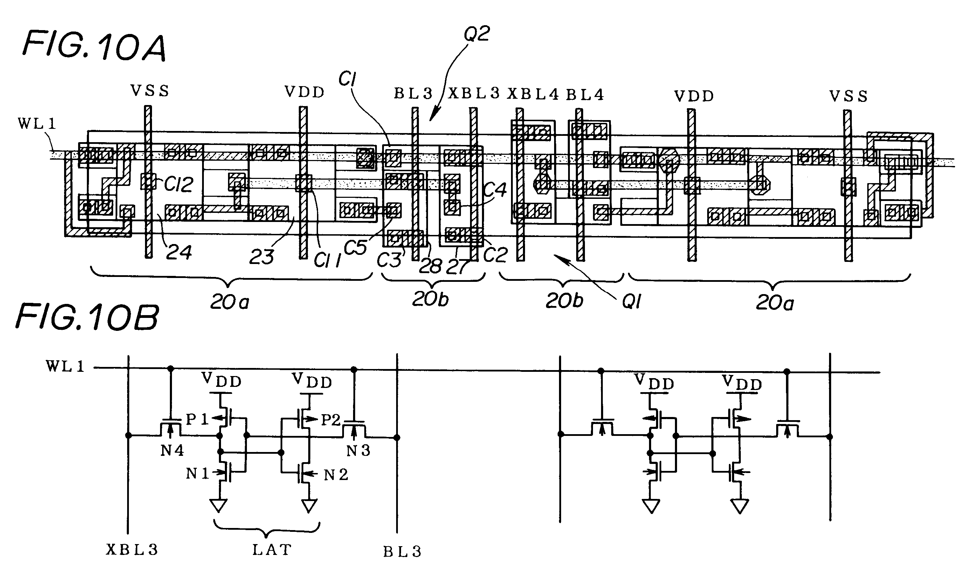

FIGS.10A and 10B are a wiring diagram and a circuit diagram of 1-port static RAM cells using the basic cells of the present embodiment.

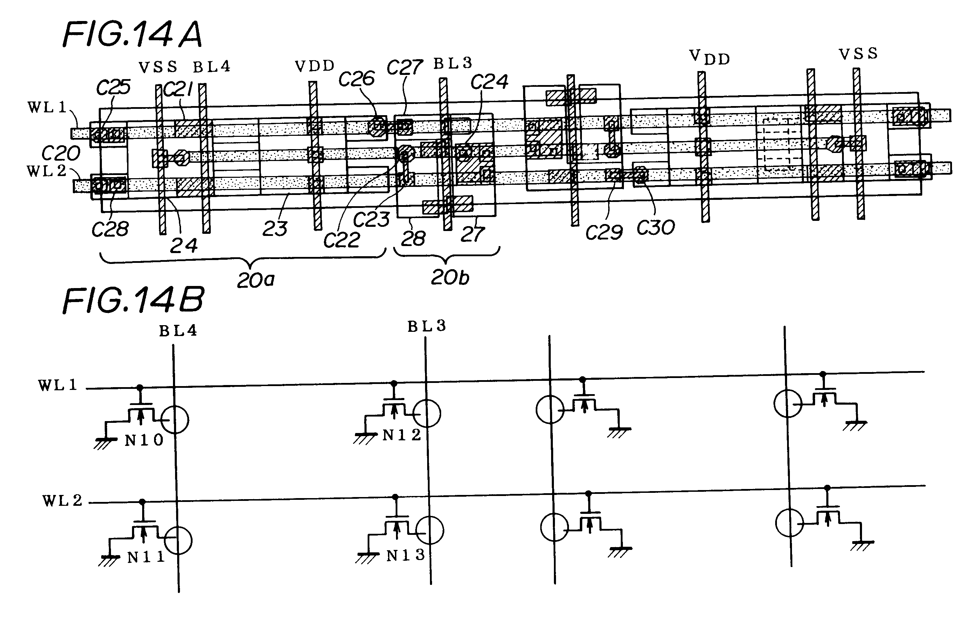

In FIG.10A and the wiring diagrams shown in FIGS.12A and 14A which will be described later, the illustration of the gate electrode is omitted for convenience' sake, and the connecting positions of the interconnection correspond to the rectangular mark in FIG.5. Furthermore, a hatching indicates a first layer aluminum interconnection and a shading indicates a second layer aluminum interconnection.

The P-channel portion 23c and the N-channel portion 24c of the respective PMOS part 23 and the NMOS part 24 in FIG.10A are respectively connected to the power source voltages V_{DD} and V_{SS} at connecting portions C11 and C12. Hence, a latch circuit LAT shown in FIG.10B formed by the CMOS forming part 20a is driven by the power source voltages V_{DD} and V_{SS}. The latch circuit LAT comprises PMOS transistors P1 and P2 and NMOS transistors N1 and N2.

The NMOS parts 28 and 27 of the NMOS forming part 20b respectively constitute transmission gates N3 and N4, and gates of these transmission gates N3 and N4 are connected to a word line WL1 at the connecting portion C1. The N-channel portions 27a and 27b are connected to a bit line XBL3 at a connecting portion C2, and the N-channel portions 28a and 28b are connected to a bit line BL3 at a connecting portion C3. The N-channel portions 27c and 28c are connected to the latch circuit LAT at respective connecting portions C4 and C5.

Therefore, the 1-port static RAM cell amounting to one bit is constituted by using all of the basic cell 20.

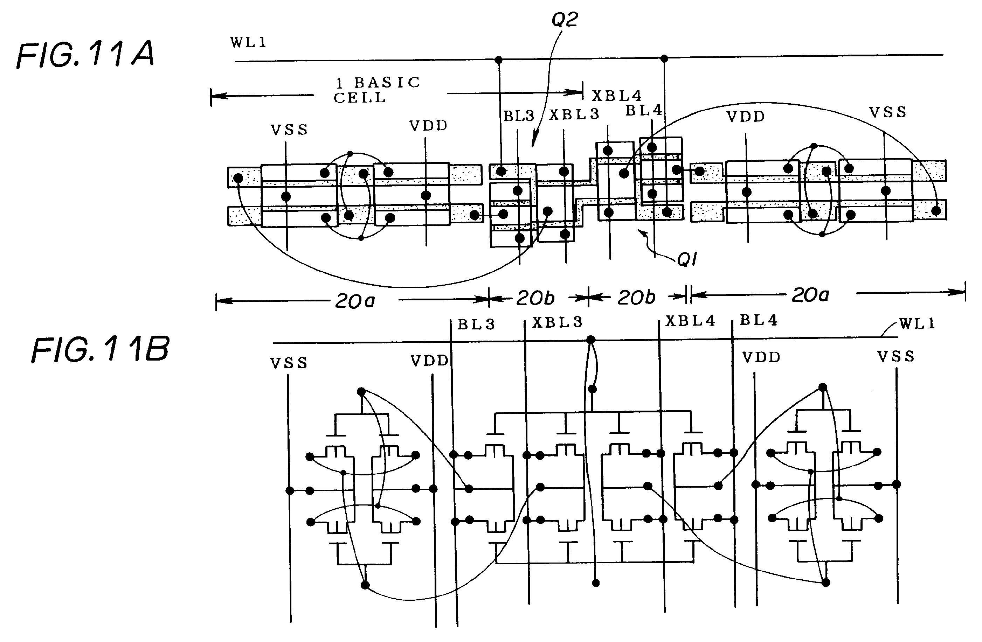

The actual pattern shown in FIG.10A is complex and hence difficult to understand. FIG.11A shows a portion of the pattern shown in FIG.10A with the connections indicated by lines so as to facilitate the understanding of FIG.10A. FIG.11B is a circuit diagram showing the equivalent circuit of FIG.11A. In FIGS.11A and 11B, those parts which are the same as those corresponding parts in FIGS.10A and 10B are designated by the same reference numerals, and a description thereof will be omitted.

In FIGS.10A and 11A, the transistors formed at a location Q1 are shifted upwardly in the figures compared to the transistors formed at a location Q2, thereby preventing the increase in the space occupied by the transistors in the horizontal direction in the figures. The portion 29a essentially formed by the vertical positional difference between the locations Q1 and Q2 is effectively used for providing the contact as described before in conjunction with FIG.4.

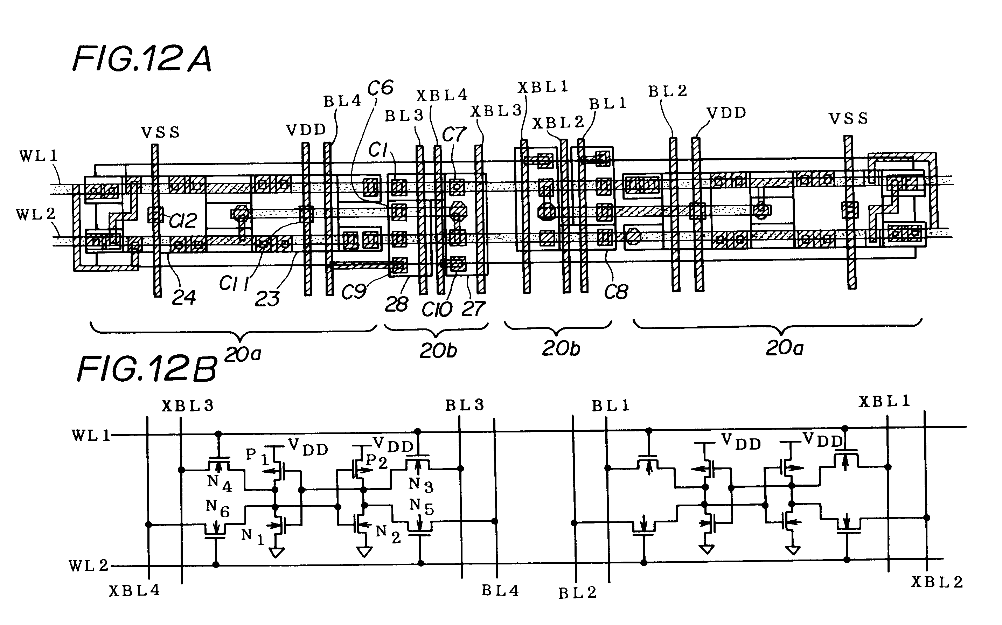

FIGS.12A and 12B are a wiring diagram and a circuit diagram of 2-port static RAM cells using the basic cells of the present embodiment.

FIGS.12A and 12B differ from FIGS.10A and 10B in the following respects. That is, two word lines WL1 and WL2 are provided, and four bit lines BL3, XBL3, BL4 and XBL4 are provided for one bit. The gates of the transmission gates N3 and N4 formed in the respective NMOS parts 28 and 27 are connected in common to the word line WL1 at the connecting portion C1. The N-channel portions 28b and 27b of the NMOS parts 28 and 27 are connected to the bit lines BL3 and XBL3 at respective connecting portions C6 and C7. In addition, gates of transmission gates N5 and N6 are connected in common to the word line WL2 at a connecting portion C8, and the N-channel portions 28a and 27a of the NMOS parts 28 and 27 are connected to the bit lines BL4 and XBL4 at respective connecting portions C9 and C10.

Therefore, the 2-port static RAM cell amounting to one bit is constituted by using all of the basic cell 20.

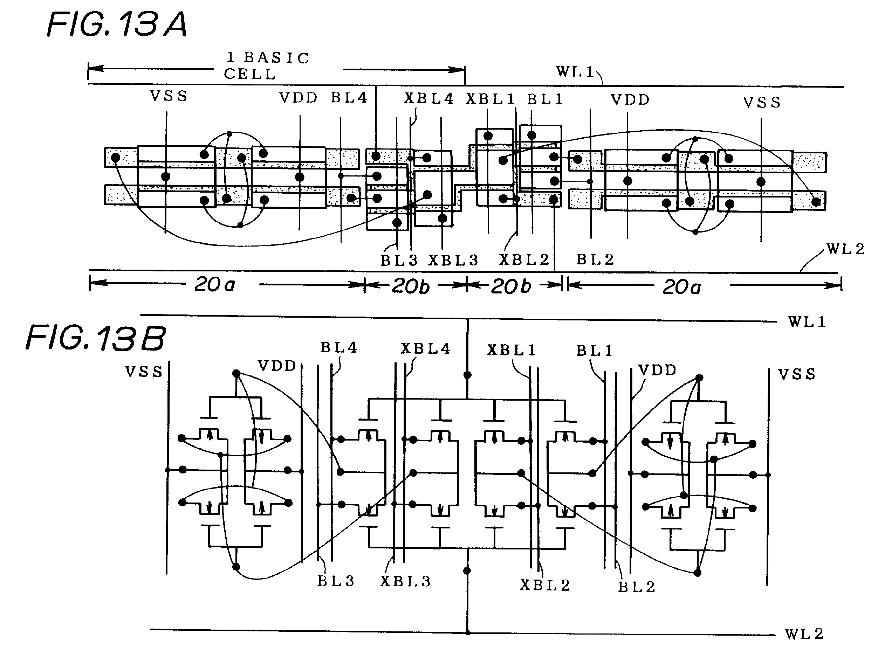

The actual pattern shown in FIG.12A is complex and hence difficult to understand. FIG.13A shows a portion of the pattern shown in FIG.12A with the connections indicated by lines so as to facilitate the understanding of FIG.12A. FIG.13B is a circuit diagram showing the equivalent circuit of FIG.13A. In FIGS.13A and 13B, those parts which are the same as those corresponding parts in FIGS.12A and 12B are designated by the same reference numerals, and a description thereof will be omitted.

FIGS.14A and 14B are a wiring diagram and a circuit diagram of ROM cells using the basic cells of the present embodiment.

Sources of NMOS transistors N10 and N11 formed by the NMOS part 24 and sources of NMOS transistors N12 and N13 formed by the NMOS parts 27 and 28 (that is, the N-channel portions 24c, 27c and 28c) are connected in common to the power source voltage V_{SS} at connecting portions C20 through C24. In addition, P-channel portions 23a, 23b and 23c of the PMOS part 23 are connected to the power source voltage V_{DD} so that the PMOS transistor will not operate.

The gates of the NMOS transistors N10 and N12 are connected to the word line WL1 at connecting portions C25 through C27. The NMOS transistors N11 and N13 are connected to the word line WL2 at connecting portions C28 through C30. The ROM cell is programmed depending on whether or not drains of the NMOS transistors N10 and N11 (N-channel portions 24a and 24b) are connected to the bit line BL4 and whether or not drains of the NMOS transistors N12 and N13 (N-channel portions 27a, 27b, 28a and 28b) are connected to the bit line BL3. In other words, the ROM cell is programmable.

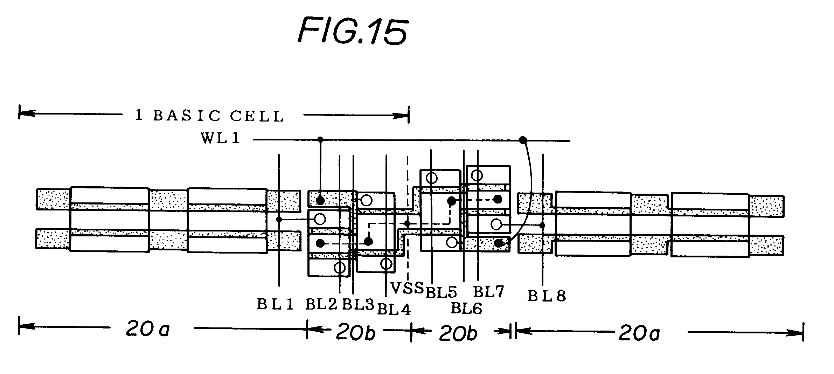

The actual pattern shown in FIG.14A is complex and hence difficult to understand. FIG.15 shows a portion of the pattern shown in FIG.14A with the connections indicated by lines so as to facilitate the understanding of FIG.14A. In FIG.15, those parts which are the same as those corresponding parts in FIGS.14A and 14B are designated by the same reference numerals, and a description thereof will be omitted. In FIG.15 and FIGS.18 and 21A which will be described later, circular marks other than the black circular marks denote program contacts where a contact can be made depending on the programming which is carried out.

Therefore, when using the basic cells 20 to constitute logic unit cells, the unused NMOS forming part 20b which is not used for the logic unit cells can be effectively utilized as the interconnection channels. When forming the RAM, 100% of the basic cell 20 can be used, and there is no unused or wasted portions of the basic cell 20. When forming the ROM, virtually all of the basic cells can be used except for the PMOS part 23. Hence, the utilization efficiency of the basic cells 20 is extremely high according to the present embodiment.

The logic unit cell, the RAM cell, the ROM cell and the like can be formed by use of the basic cell 20, with a similar utilization efficiency to that of the embodiment described before.

Therefore, according to the described embodiment and modification, the utilization efficiency of the basic cell is extremely high when forming the logic unit cell, the RAM, the ROM and the like. There is virtually no unused or wasted portion of the basic cell, thereby greatly improving the integration density of the semiconductor integrated circuit.

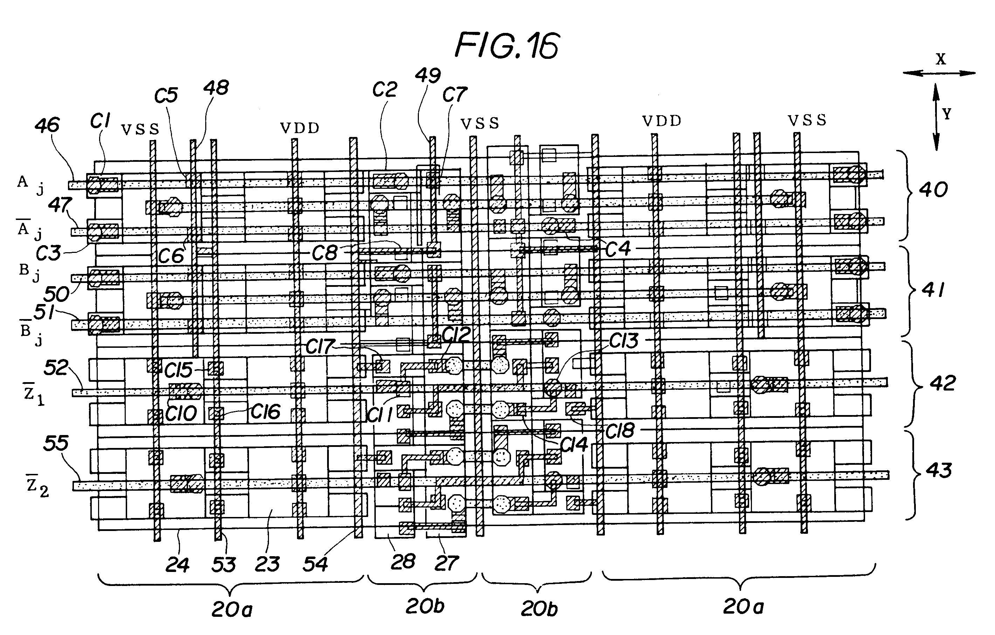

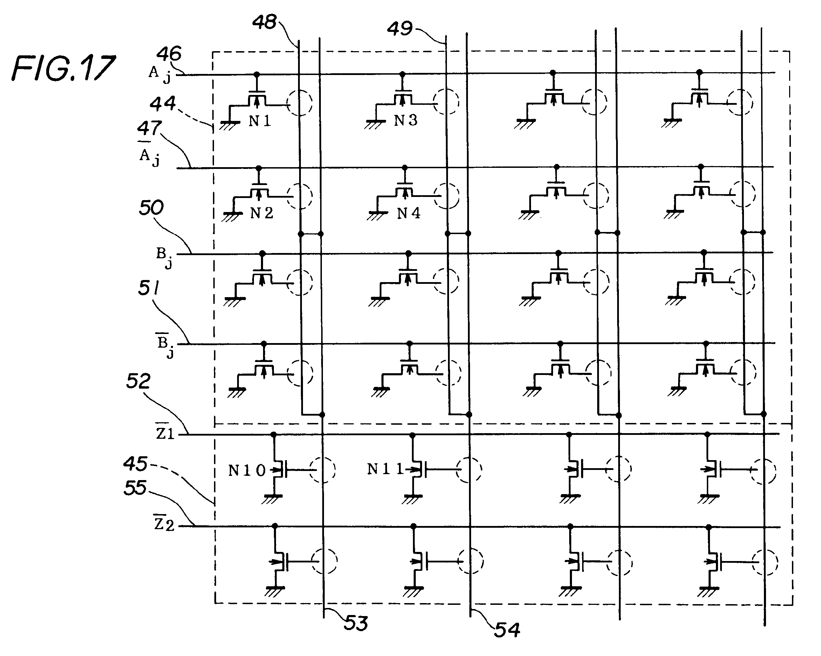

Next, a description will be given on the formation of a programmable logic array (PLA) by use of the basic cells. FIGS.16 and 17 are a wiring diagram and a circuit diagram respectively showing a first embodiment of the PLA. In FIGS.16 and 17, those parts which are the same as those corresponding parts in FIGS.3 through 5 are designated by the same reference numerals, and a description thereof will be omitted. In addition, the illustration of the gate electrode is omitted for convenience' sake, and the connecting position of the interconnection corresponds to the rectangular mark in FIG.5.

In FIG.16, a hatching indicates a first layer aluminum interconnection (wiring), and a shading indicates a second layer aluminum interconnection (wiring). In addition, a first column 40 of the basic cells 20 and a second column 41 of the basic cells 20 constitute an AND plane 44, while a third column 42 of the basic cells 20 and a fourth column 43 of the basic cells 20 constitute an OR plane 45.

In the first column 40, the p-channel portions 23a, 23b and 23c of the PMOS part 23 are connected to the power source voltage V_{DD} so that the PMOS transistor does not operate. On the other hand, N-channel portions 24c, 27c and 28c of the respective NMOS parts 24, 27 and 28 are connected to the power source voltage V_{SS}.

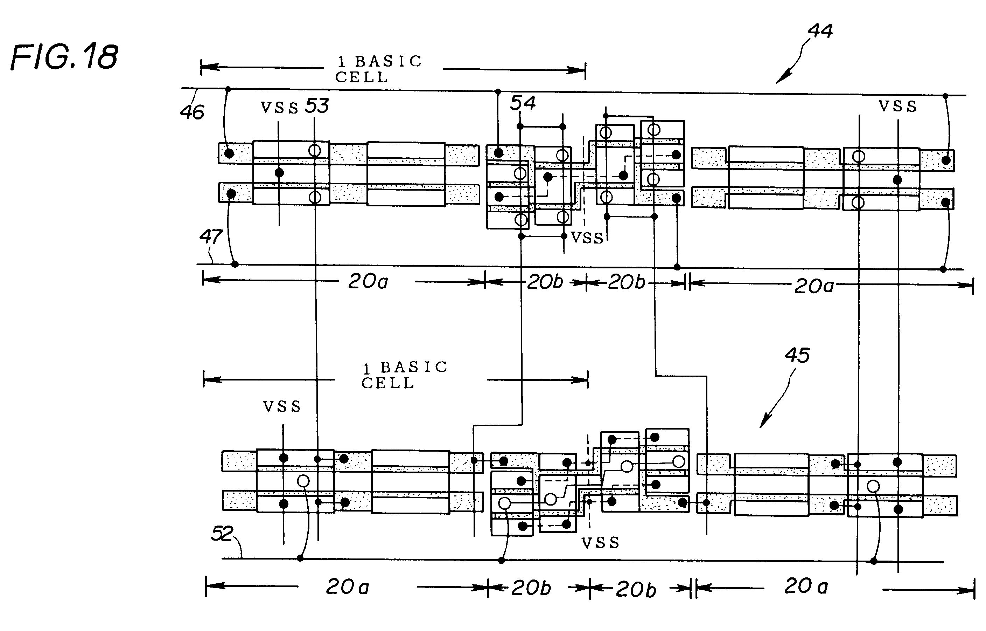

An input line 46 which extends in the X-direction and receives a signal Aⱼ is connected to the gate electrodes 21 and 25 at the connecting portions C1 and C2. An input line 47 which extends in the X-direction and receives a signal A̅ⱼ is connected to the gate electrodes 22 and 26 at the connecting portions C3 and C4. Accordingly, the two NMOS transistors N1 and N2 shown in FIG.18 are formed at the N-channel portions 24a and 24c and N-channel portions 24b and 24c of the NMOS part 24. Furthermore, the two NMOS transistors N3 and N4 are formed at the N-channel portions 27b, 28b, 27c and 28c of the NMOS parts 27 and 28 and the N-channel portions 27a, 28a, 27c and 28c of the N-channel parts 27 and 28.

Product term lines 48 and 49 are provided on the respective NMOS parts 24 and 27 and extend in the Y-direction. The programming of the PLA is carried out by connecting the drains of the NMOS transistors N1 through N4 to the product term lines 48 and 49 at the connecting portions C5 through C8. In FIG.17, portions where the programming is carried out are encircled by phantom lines.

The arrangement is similar for the second column 41 in which input lines 50 and 51 extend in the Y-direction.

In the third column 42, the P-channel portions 23a, 23b and 23c of the PMOS part 23 are connected to the power source voltage V_{DD} so that the PMOS transistor does not operate. On the other hand, N-channel portions 24c, 27c and 28c of the respective NMOS parts 24, 27 and 28 are connected to the power source voltage V_{SS}.

An output line 52 which extends in the X-direction and outputs a signal Z̅₁ is connected to the N-channel portion 24c, the N-channel portions 28b and 27b and the N-channel portions 28a and 27a at the connecting portion C10, the connecting portions C11 and C12 and the connecting portion C13. Accordingly, the NMOS transistor N10 shown in FIG.17 is formed by the NMOS part 24, and the NMOS transistor N11 is formed by the NMOS parts 27 and 28.

Product term lines 53 and 54 extend in the Y-direction on the wide portions 21a and 22a of the CMOS forming part 20a. These product term lines 53 and 54 are respectively connected to the product term lines 48 and 49. The programming is carried out by connecting the gates of the transistors N10 and N11 to the product term lines 53 and 54 at the connecting portions C15 and C16 and the connecting portions C17 and C18.

The arrangement is similar for the fourth column 43 in which an output line 55 extends in the Y-direction.

Therefore, the basic cell 20 has the CMOS forming part 20a and the NMOS forming part 20b, and the utilization efficiency of the basic cells 20 is greatly improved because there are more NMOS transistors constituted by the basic cells 20 than PMOS transistors.

In addition, since the product term lines 48 and 49 for the AND plane 44 and the product term lines 53 and 54 for the OR plane 45 are provided independently, it is also possible to form a plurality of transistors in the OR plane 45 by use of a single basic cell 20, and the utilization efficiency of the basic cells 20 is greatly improved.

The actual pattern shown in FIG.16 is complex and hence difficult to understand. FIG.18 shows a portion of the pattern shown in FIG.16 with the connections indicated by lines so as to facilitate the understanding of FIG.16. In FIG.18, those parts which are the same as those corresponding parts in FIG.16 are designated by the same reference numerals, and a description thereof will be omitted.

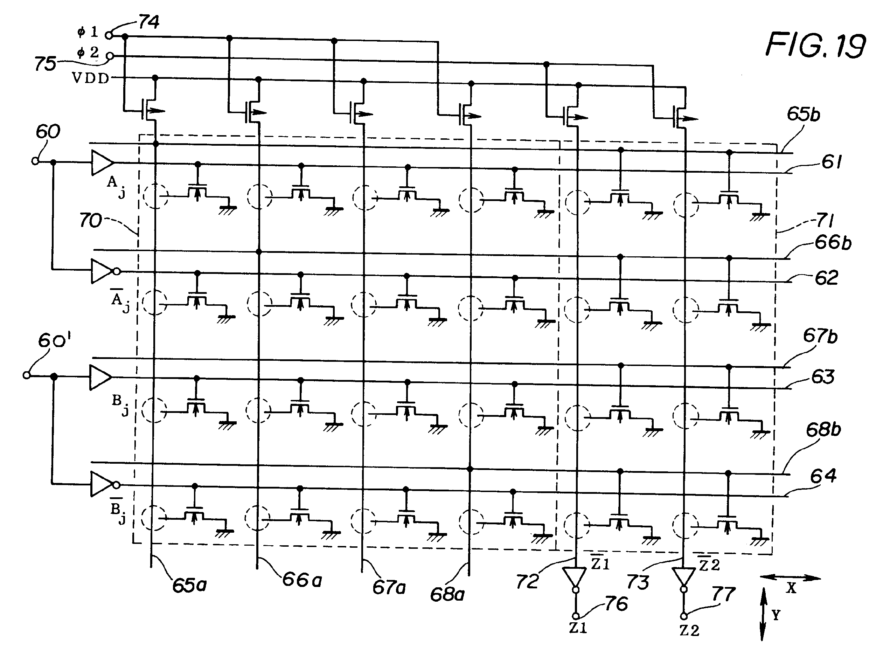

FIG.19 is a circuit diagram of a second embodiment of the PLA. In FIG.19, terminals 60 and 60′ receive the input signals Aⱼ and Bⱼ, and the signals Aⱼ, A̅ⱼ, Bⱼ and B̅ⱼ are respectively supplied to input lines 61 through 64 extending in the X-direction.

The input lines 61 through 64 extend in the Y-direction and cross perpendicularly to product term lines 65a through 68a. NMOS transistors of an AND plane 70 are provided at intersections of the input lines 61 through 64 and the product term lines 65a through 68a. Product term lines 65b through 68b which extend in the X-direction are respectively connected to the product term lines 65a through 68a.

Output lines 72 and 73 which are provided on the right of the product term lines 65a through 68a in the X-direction extend in the Y-direction and cross perpendicularly to the product term lines 65b through 68b. NMOS transistors of an OR plane 71 are provided at the intersections of the output lines 72 and 73 and the product term lines 65b through 68b.

The NMOS transistors of the AND plane 70 have gates thereof grounded and respectively connected to the input lines 61 through 64. The programming is carried out by connecting drains of the NMOS transistors to the respective product term lines 65a through 68a at portions encircled by phantom lines. The NMOS transistors of the OR plane 71 have sources thereof grounded and respectively connected to the product term lines 65b through 68b. The programming is carried out by connecting drains of the NMOS transistors of the OR plane 71 to the respective output lines 72 and 73.

Clock signals φ₁ and φ₂ having mutually different phases are applied to terminals 74 and 75, respectively. The output signals Z₁ and Z₂ are outputted from respective terminals 76 and 77.

In the present embodiment, there are also provided the product term lines 65a through 68a for the AND plane 70 and the product term lines 65b through 68b are provided for the OR plane 71 which cross perpendicularly to the product term lines 65a through 68a. Hence, it is possible to arrange the AND plane 70 and the OR plane 71 in the X-direction, and the NMOS transistors formed from the basic cells 20 shown in FIGS.3 through 5 can be used efficiently in both the AND plane 70 and the OR plane 71.

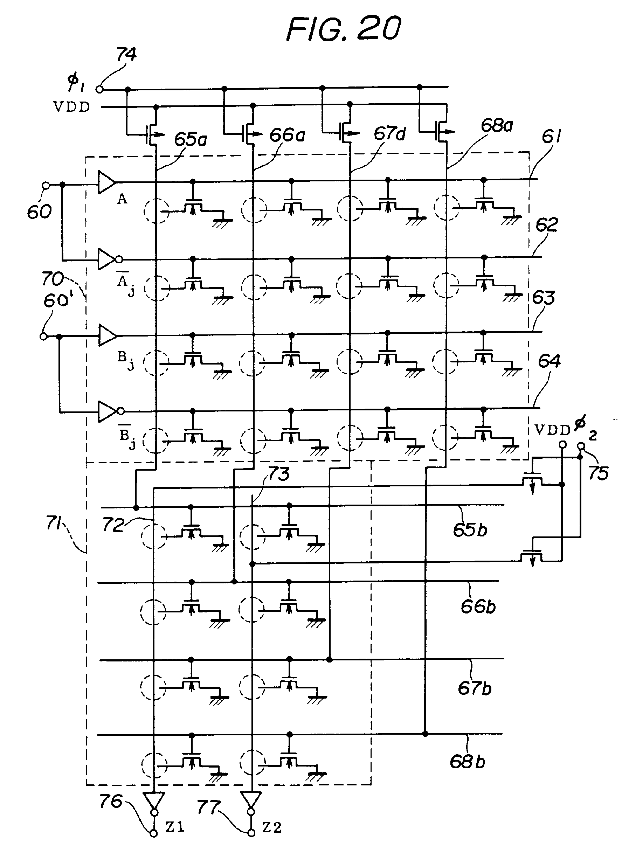

FIG.20 is a circuit diagram of a third embodiment of the PLA. In FIG.20, those parts which are the same as those corresponding parts in FIG.19 are designated by the same reference numerals, and a description thereof will be omitted. In FIG.20, the product term lines 65b through 68b which extend in the X-direction are arranged below the AND plane 70 and are connected to the product term lines 65a through 68a. Accordingly, it is possible to arrange the OR plane 71 in the Y-direction to the AND plane 70, and the basic cells 20 can be utilized efficiently both in the AND plane 70 and the OR plane 71 as in the case of the second embodiment of the PLA.

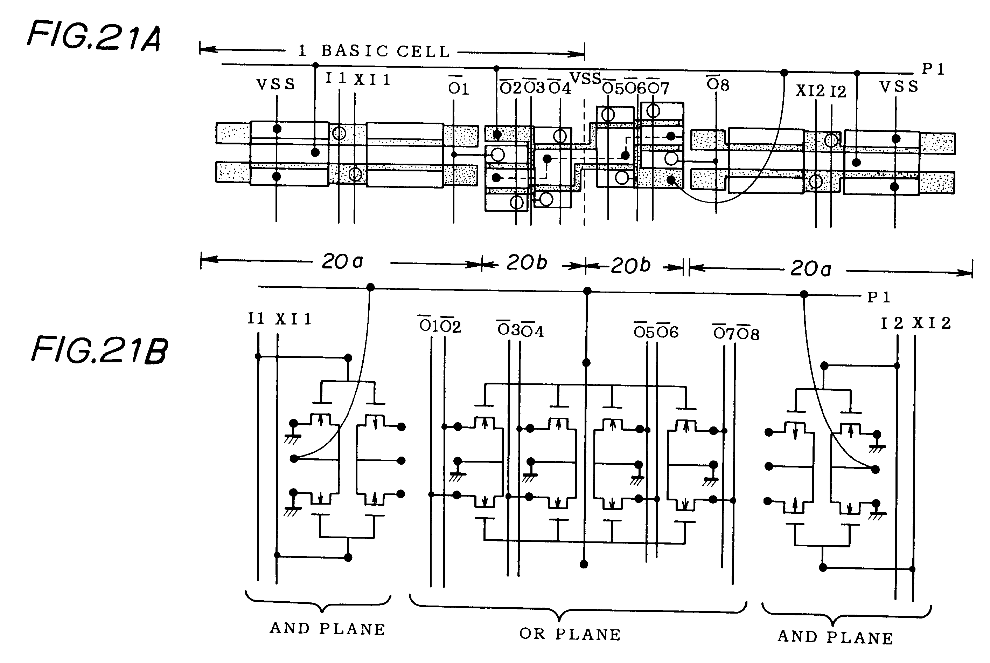

FIG. 21A shows a portion of a fourth embodiment of the PLA with the connections indicated by lines to facilitate the understanding thereof. FIG.21B is a circuit diagram showing the equivalent circuit of FIG.21A. In FIGS.21A and 21B, P1 denotes a product term line, I1, XI1, I2 and XI2 denote input lines, and O1 through O8 denote output lines. In the first through third embodiments of the PLA, the large and small transistors of the basic cells are used for both the AND plane and the OR plane. But in the present embodiment, the large transistors are used for the AND plane, and the small transistors are used only for the OR plane. In the present embodiment, the number of output lines is greater than the number of input lines.

Therefore, according to the embodiments of the PLA, it is possible to constitute the PLA by the master slice type semiconductor integrated circuit by efficiently utilizing the basic cells. As a result, the field of application of the master slice type semiconductor integrated circuit is considerably expanded.

## Claims

1. A master slice type semiconductor integrated circuit comprising:
- a semiconductor chip (10);
- input/output cells (12) arranged in a peripheral portion of said semiconductor chip; and
- basic cells (20) arranged in a central portion of said semiconductor chip,
each of said basic cells including a first portion (20a) containing complementary MOSFETs in the form of pairs of first and second N-channel MOSFETs and first and second P-channel MOSFETs,
the P-channel MOSFETs of said pairs comprising first and second P-type regions spaced from each other in a first, column, direction (Y) by an N-type channel region, oriented in a second direction (X) perpendicular to said first direction insulatingly overlaid by a conductive gate electrode (21, 22);
the N-channel MOSFETs of said pairs comprising first and second N-type regions spaced from each other in said first column direction by an P-type channel region oriented in said second direction insulatingly overlaid by a conductive gate electrode (21, 22);
said first regions, second regions, channel regions, and gate electrodes of the N-channel MOSFETs of said pairs being located adjacent said first regions, second regions, channel regions, and gate electrodes of the P-channel MOSFETs of said pairs, respectively, in said second direction (X);
each of said basic cells further including a second portion (20b) containing third and fourth MOSFETs of the NMOS type;
said second portion of each of said basic cells being located adjacent said first portion of a respective one of said basic cells in said second direction (X);
said second portion of each of said basic cells containing at least one MOSFET comprising first and second N-type regions (28b,28c), spaced from each other by a P-type channel region insulatingly overlaid by a conductive gate electrode; characterized in that said first and second N-type regions of said second portion are spaced from each other in said first direction (Y); and that the conductive gate electrode of said at least one MOSFET is offset in said first column direction (Y) from the conductive gates of any of the MOSFETs of said first portion (20a) containing complementary MOSFETs to allow one of said first (28b) or second (28c) N-type regions of said second portion to be connected to one of said gate electrodes (22a) in said first portion directly by an interconnection aligned in said second direction.

2. A master slice type semiconductor integrated circuit as claimed in claim 1, wherein the conductive gate electrode of said P-channel MOSFET and the conductive gate electrode of said N-channel MOSFET in each of said pairs are integrally formed by a common electrode.

3. A master slice type semiconductor integrated circuit as claimed in claim 1, wherein said basic cells form a plurality of basic cell columns which are arranged in a direction (X) perpendicular to said first column direction (Y) so that said first portions (20a) of said adjacent basic cell columns are adjacent each other and said second portions (20b) of said adiacent basic cells columns are adjacent each other.

4. A master slice type semiconductor integrated circuit as claimed in claim 3, wherein between two of said basic cell columns having adjacent first portions (20a), the conductive gate electrode (25, 26) of said second portion (20b) in one of said two basic cell columns and the conductive gate electrode (25,26) of said second portion (20b) in the other one of said two basic cell columns are offset along said first column direction (Y).

5. A master slice type semiconductor integrated circuit as claimed in claim 3, wherein between two of said basic cell columns having adjacent second portions (20b), the conductive gate electrode (25,26) said second portion (20b) in one of said two basic cell columns and the conductive gate electrode (25,26) of said second portion in the other one of said two basic cell columns are offset along said first column direction (Y).

6. A master slice type semiconductor integrated circuit as claimed in claim 1, wherein in said first portion said second region of said first P-channel MOSFET and said first region of said second P-channel MOSFET are formed by a common P-type region (24c), and said second region of said second N-channel MOSFET and said first region of said first N-channel MOSFET are formed by a common N-type region (23c).

7. A master slice type semiconductor integrated circuit as claimed in claim 6, wherein said second portion (20b) further includes fifth and sixth N-channel MOSFETs, said third and fourth N-channel MOSFETs being arranged in said first column direction and including first (28a), second (28b) and third (28c) N-type regions, said fifth and sixth N-channel MOSFETs being arranged in said first column direction spaced from said third and fourth N-channel MOSFETs in said second direction (X) and including fourth (27a), fifth (27b) and sixth (27c) N-type regions, and said fourth and sixth N-channel MOSFETs having conductive gate electrodes which are offset in said first column direction.

8. A master slice type semiconductor integrated circuit as claimed in claim 7, wherein said conductor gate electrodes of said third and fifth N-channel MOSFETs are formed by a linear integral electrode, and said fourth and sixth N-channel MOSFETs have conductor gate electrodes which are formed by an integral electrode.

9. A master slice type semiconductor integrated circuit as claimed in claim 8, wherein said basic cells form a plurality of basic cell columns which are arranged in a direction perpendicular to said first column direction, said conductive gate electrodes of said fourth and sixth N-channel MOSFETs in said second portion of one of said basic cells and said conductive gate electrodes of said fourth and sixth N-channel MOSFETs in said second portion of an adjacent basic cell are respectively formed by an integral common electrode, and said conductive gate electrodes of said third and fifth N-channel MOSFETs of said one of said basic cells and said conductive gate electrodes of said third and fifth N-channel MOSFETs of said adjacent basic cells are respectively formed by an integral common electrode.

10. A master slice type semiconductor integrated circuit as claimed in claim 7, wherein the width of said conductive gate electrode in said first direction on both sides of said channel region along said second direction is greater than that at a part overlying said channel region for each of said P-channel MOSFETs and said N-channel MOSFETs to define gate electrode contact regions.

11. A master slice type semiconductor integrated circuit as claimed in claim 7, wherein the width of said conductive gate electrode of said P-channel and N-channel MOSFETs within said first portion along said second direction is greater than the width of said conductive gate electrode of said MOSFETs within said second portion along said second direction.

12. A master slice type semiconductor integrated circuit as claimed in claim 1, operable as a single port static random access memory and comprising :
a word line (WL1) ;
a plurality of bit lines (BL3, XBL3,...) ;
a first power source line for receiving a first power source voltage (V_{DD}); and
a second power source line for receiving a second power source voltage (V_{SS});
each of said basic cells forming a memory cell including a latch circuit formed by two pairs (P1, N1, P2, N2) of N-channel MOSFETs and P-channel MOSFETs within said first portion,
each of said N-channel MOSFETs within said second portion forming a transmission gate which is connected to a corresponding one of the bit lines (BL3, ...),
each of said transmission gates being coupled to the latch circuit of one memory cell and being connected to a common word line (WL1),
the N-type channel region (23c) of the P-channel MOSFET being connected to said first power source line (V_{DD}),
the P-type channel region of the N-channel MOSFET being connected to said second power source line (V_{SS}).

13. A master slice type semiconductor integrated circuit as claimed in claim 1, operable as a dual port random access memory and comprising :
a plurality of word lines (WL1, WL2,...);
a plurality of bit lines (BL1, XBL1, BL3, ...);
a first power source line for receiving a first power source voltage (V_{DD}); and
a second power source line for receiving a second power source voltage (V_{SS});
each of said basic cells forming a memory cell including a latch circuit formed by said two pairs (P1, N1, P2, N2) of N-channel MOSFETs and P-channel MOSFETs within said first portion,
each of said N-channel MOSFETs (N3, N4, N5, N6) within said second portion forming a transmission gate which is coupled to a corresponding one of the bit lines (BL1, ...) and to a corresponding one of the word lines (WL1, ...),
the N-type channel region of the P-channel MOSFET being connected to said first power source line,
the P-type channel region of the N-channel MOSFET being connected to said second power source line.

14. A master slice type semiconductor integrated circuit as claimed in claim 1, operable as a read only memory and comprising :
a plurality of word lines (WL1, WL2,...) ;
a plurality of bit lines (BL3, BL4,...) ;
a first power source line for receiving a first power source voltage ; and
a second power source line for receiving a second power source voltage;
each of said basic cells forming memory cells by said N-channel MOSFETs (N10, N11,...) within said second portion,
each of said memory cells being connected to one of the word lines (WL1, ...) and to one of the bit lines (...BL3,...),
said first power source line being connected in common to the source regions of the N-channel MOSFETs within said first and second portions,
said second power source line being connected in common to the first and second P-type regions of the P-channel MOSFETs within said first portion.

15. A master slice type semiconductor integrated circuit as claimed in claim 1, operable as a programmable logic array and comprising :
input lines (46,47) ;
first product term lines (48, 49) ;
second product term lines (53, 54) connected to said first product term lines ;
an AND plane (44) comprising first and second columns of said basic cells ;
an OR plane (45) comprising third and fourth columns of said basic cells ;
each of said basic cells including in the second portion, four N-channel MOSFETs, and an output line (52).

## Patentansprüche

1. Eine integrierte Halbleiterschaltung des Master-Slice-Typs mit:
- einem Halbleiterchip (10);
- Eingabe-/Ausgabezellen (12), die in einem peripheren Abschnitt des genannten Halbleiterchips angeordnet sind; und
- Basiszellen (20), die in einem zentralen Abschnitt des genannten Halbleiterchips angeordnet sind,
bei der jede der genannten Basiszellen einen ersten Abschnitt (20a) umfaßt, der komplementäre MOSFETs in der Form von Paaren von ersten und zweiten N-Kanal-MOSFETs und ersten und zweiten P-Kanal-MOSFETs enthält,
welche P-Kanal-MOSFETs der genannten Paare erste und zweite P-Typ-Zonen umfassen, die in einer ersten Richtung, einer Spaltenrichtung (Y) durch eine N-Typ-Kanalzone räumlich voneinander getrennt angeordnet sind, die in einer zweiten Richtung (X) rechtwinklig zu der genannten ersten Richtung ausgerichtet ist, von einer leitfähigen Gateelektrode (21, 22) isolierend überlagert;
welche N-Kanal-MOSFETs der genannten Paare erste und zweite N-Typ-Zonen umfassen, die in der genannten ersten Spaltenrichtung, durch eine P-Typ-Kanalzone räumlich voneinander getrennt angeordnet sind, die in der genannten zweiten Richtung ausgerichtet ist, von einer leitfähigen Gateelektrode (21, 22) isolierend überlagert;
welche ersten Zonen, zweiten Zonen, Kanalzonen und Gateelektroden der N-Kanal-MOSFETs der genannten Paare angrenzend an die genannten ersten Zonen, zweiten Zonen, Kanalzonen bzw. Gateelektroden der P-Kanal-MOSFETs der genannten Paare in der genannten zweiten Richtung (X) angeordnet sind;
bei der jede der genannten Basiszellen ferner einen zweiten Abschnitt (20b) umfaßt, der dritte und vierte MOSFETs des NMOS-Typs enthält;
welcher zweite Abschnitt von jeder der genannten Basiszellen angrenzend an den genannten ersten Abschnitt einer jeweiligen der genannten Basiszellen in der genannten zweiten Richtung (X) angeordnet ist;
welcher zweite Abschnitt von jeder der genannten Basiszellen wenigstens einen MOSFET enthält, der erste und zweite N-Typ-Zonen (28b, 28c) umfaßt, die durch eine P-Typ-Kanalzone räumlich voneinander getrennt angeordnet sind, von einer leitfähigen Gateelektrode isolierend überlagert; dadurch gekennzeichnet, daß die genannten ersten und zweiten N-Typ-Zonen des genannten zweiten Abschnittes in der genannten ersten Richtung (Y) räumlich voneinander getrennt angeordnet sind; und daß die leitfähige Gateelektrode des genannten wenigstens einen MOSFET in der genannten ersten Spaltenrichtung, (Y) von den leitfähigen Gates jeglicher MOSFETs des genannten ersten Abschnittes (20a), der komplementäre MOSFETs enthält, versetzt ist, um eine der genannten ersten (28b) oder zweiten (28c) N-Typ-Zonen des genannten zweiten Abschnittes mit einer der genannten Gateelektroden (22a) in dem genannten ersten Abschnitt direkt durch eine Zwischenverbindung verbinden zu können, die in der genannten zweiten Richtung ausgerichtet ist.

2. Eine integrierte Halbleiterschaltung des Master-Slice-Typs nach Anspruch 1, bei der die leitfähige Gateelektrode des genannten P-Kanal-MOSFET und die leitfähige Gateelektrode des genannten N-Kanal-MOSFET in jedem der genannten Paare durch eine gemeinsame Elektrode integral gebildet sind.

3. Eine integrierte Halbleiterschaltung des Master-Slice-Typs nach Anspruch 1, bei der die genannten Basiszellen eine Vielzahl von Basiszellenspalten bilden, die in einer Richtung (X) angeordnet sind, die zu der genannten ersten Richtung, der Spaltenrichtung, (Y) rechtwinklig ist, so daß die genannten ersten Abschnitte (20a) der genannten aneinandergrenzenden Basiszellenspalten aneinandergrenzen und die genannten zweiten Abschnitte (20b) der genannten aneinandergrenzenden Basiszellenspalten aneinandergrenzen.

4. Eine integrierte Halbleiterschaltung des Master-Slice-Typs nach Anspruch 3, bei der zwischen zweien der genannten Basiszellenspalten mit aneinandergrenzenden ersten Abschnitten (20a) die leitfähige Gateelektrode (25, 26) des genannten zweiten Abschnittes (20b) in einer der genannten zwei Basiszellenspalten und die leitfähige Gateelektrode (25, 26) des genannten zweiten Abschnittes (20b) in der anderen der genannten zwei Basiszellenspalten längs der genannten ersten Spaltenrichtung, (Y) versetzt sind.

5. Eine integrierte Halbleiterschaltung des Master-Slice-Typs nach Anspruch 3, bei der zwischen zweien der genannten Basiszellenspalten mit aneinandergrenzenden zweiten Abschnitten (20b) die leitfähige Gateelektrode (25, 26) des genannten zweiten Abschnittes (20b) in einer der genannten zwei Basiszellenspalten und die leitfähige Gateelektrode (25, 26) des genannten zweiten Abschnittes in der anderen der genannten zwei Basiszellenspalten längs der genannten ersten Spaltenrichtung, (Y) versetzt sind.

6. Eine integrierte Halbleiterschaltung des Master-Slice-Typs nach Anspruch 1, bei der in dem genannten ersten Abschnitt die genannte zweite Zone des genannten ersten P-Kanal-MOSFET und die genannte erste Zone des genannten zweiten P-Kanal-MOSFET durch eine gemeinsame P-Typ-Zone (24c) gebildet sind, und die genannte zweite Zone des genannten zweiten N-Kanal-MOSFET und die genannte erste Zone des genannten ersten N-Kanal-MOSFET durch eine gemeinsame N-Typ-Zone (23c) gebildet sind.

7. Eine integrierte Halbleiterschaltung des Master-Slice-Typs nach Anspruch 6, bei der der genannte zweite Abschnitt (20b) ferner fünfte und sechste N-Kanal-MOSFETs enthält, welche dritten und vierten N-Kanal-MOSFETs in der genannten ersten Richtung, der Spaltenrichtung, angeordnet sind und erste (28a), zweite (28b) und dritte (28c) N-Typ-Zonen enthalten, welche fünften und sechsten N-Kanal-MOSFETs in der genannten ersten Spaltenrichtung, getrennt von den genannten dritten und vierten N-Kanal-MOSFETs in der genannten zweiten Richtung (X) angeordnet sind und vierte (27a), fünfte (27b) und sechste (27c) N-Typ-Zonen enthalten, und welche vierten und sechsten N-Kanal-MOSFETs leitfähige Gateelektroden haben, die in der genannten ersten Spaltenrichtung, versetzt sind.

8. Eine integrierte Halbleiterschaltung des Master-Slice-Typs nach Anspruch 7, bei der die genannten leitfähigen Gateelektroden der genannten dritten und fünften N-Kanal-MOSFETs durch eine lineare integrale Elektrode gebildet sind und die genannten vierten und sechsten N-Kanal-MOSFETs leitfähige Gateelektroden haben, die durch eine integrale Elektrode gebildet sind.

9. Eine integrierte Halbleiterschaltung des Master-Slice-Typs nach Anspruch 8, bei der die genannten Basiszellen eine Vielzahl von Basiszellenspalten bilden, die in einer Richtung angeordnet sind, die zu der genannten ersten Spaltenrichtung, rechtwinklig ist, die genannten leitfähigen Gateelektroden der genannten vierten und sechsten N-Kanal-MOSFETs in dem genannten zweiten Abschnitt einer der genannten Basiszellen und die genannten leitfähigen Gateelektroden der genannten vierten und sechsten N-Kanal-MOSFETs in dem genannten zweiten Abschnitt einer angrenzenden Basiszelle jeweils durch eine integrale gemeinsame Elektrode gebildet sind; und die genannten leitfähigen Gateelektroden der genannten dritten und fünften N-Kanal-MOSFETs der genannten einen der genannten Basiszellen und die genannten leitfähigen Gateelektroden der genannten dritten und fünften N-Kanal-MOSFETs der genannten angrenzenden Basiszelle jeweils durch eine integrale gemeinsame Elektrode gebildet sind.

10. Eine integrierte Halbleiterschaltung des Master-Slice-Typs nach Anspruch 7, bei der die Breite der genannten leitfähigen Gateelektrode in der genannten ersten Richtung auf beiden Seiten der genannten Kanalzone längs der genannten zweiten Richtung größer als jene an einem Teil ist, der die genannte Kanalzone für jeden der genannten P-Kanal-MOSFETs und der genannten N-Kanal-MOSFETs überlagert, um Gateelektrodenkontaktzonen zu definieren.

11. Eine integrierte Halbleiterschaltung des Master-Slice-Typs nach Anspruch 7, bei der die Breite der genannten leitfähigen Gateelektrode der genannten P-Kanal- und N-Kanal-MOSFETs innerhalb des genannten ersten Abschnittes längs der genannten zweiten Richtung größer als die Breite der genannten leitfähigen Gateelektrode der genannten MOSFETs innerhalb des genannten zweiten Abschnittes längs der genannten zweiten Richtung ist.

12. Eine integrierte Halbleiterschaltung des Master-Slice-Typs nach Anspruch 1, die als statischer Einzelportspeicher mit wahlfreiem Zugriff betriebsfähig ist und umfaßt:
eine Wortleitung (WL1);
eine Vielzahl von Bitleitungen (BL3, XBL3, ...);
eine erste Energiequellenleitung zum Empfangen einer ersten Energiequellenspannung (V_{DD}); und
eine zweite Energiequellenleitung zum Empfangen einer zweiten Energiequellenspannung (V_{SS});
bei der jede der genannten Basiszellen eine Speicherzelle bildet, die eine Verriegelungsschaltung enthält, die durch zwei Paare (P1, N1, P2, N2) von N-Kanal-MOSFETs und P-Kanal-MOSFETs innerhalb des genannten ersten Abschnittes gebildet ist,
jeder der genannten N-Kanal-MOSFETs innerhalb des genannten zweiten Abschnittes ein Übertragungsgate bildet, das mit einer entsprechenden der Bitleitungen (BL3, ...) verbunden ist,
jedes der genannten Übertragungsgates mit der Verriegelungsschaltung einer Speicherzelle gekoppelt ist und mit einer gemeinsamen Wortleitung (WL1) verbunden ist,
die N-Typ-Kanalzone (23c) des P-Kanal-MOSFET mit der genannten ersten Energiequellenleitung (V_{DD}) verbunden ist,
die P-Typ-Kanalzone des N-Kanal-MOSFET mit der genannten zweiten Energiequellenleitung (V_{SS}) verbunden ist.

13. Eine integrierte Halbleiterschaltung des Master-Slice-Typs nach Anspruch 1, die als Dualportspeicher mit wahlfreiem Zugriff betriebsfähig ist und umfaßt:
eine Vielzahl von Wortleitungen (WL1,WL2, ...);
eine Vielzahl von Bitleitungen (BL1, XBL1, BL3, ...);
eine erste Energiequellenleitung zum Empfangen einer ersten Energiequellenspannung (V_{DD}); und
eine zweite Energiequellenleitung zum Empfangen einer zweiten Energiequellenspannung (V_{SS});
bei der jede der genannten Basiszellen eine Speicherzelle bildet, die eine Verriegelungsschaltung enthält, die durch die genannten zwei Paare (P1, N1, P2, N2) von N-Kanal-MOSFETs und P-Kanal-MOSFETs innerhalb des genannten ersten Abschnittes gebildet ist,
jeder der genannten N-Kanal-MOSFETs (N3, N4, N5, N6) innerhalb des genannten zweiten Abschnittes ein Übertragungsgate bildet, das mit einer entsprechenden der Bitleitungen (BL1, ...) und mit einer entsprechenden der Wortleitungen (WL1, ...) gekoppelt ist,
die N-Typ-Kanalzone des P-Kanal-MOSFET mit der genannten ersten Energiequellenleitung verbunden ist,
die P-Typ-Kanalzone des N-Kanal-MOSFET mit der genannten zweiten Energiequellenleitung verbunden ist.

14. Eine integrierte Halbleiterschaltung des Master-Slice-Typs nach Anspruch 1, die als Nur-Lese-Speicher betriebsfähig ist und umfaßt:
eine Vielzahl von Wortleitungen (WL1, WL2, ...);
eine Vielzahl von Bitleitungen (BL3, BL4, ...);
eine erste Energiequellenleitung zum Empfangen einer ersten Energiequellenspannung; und
eine zweite Energiequellenleitung zum Empfangen einer zweiten Energiequellenspannung;
bei der jede der genannten Basiszellen Speicherzellen durch die genannten N-Kanal-MOSFETs (N10, N11, ...) innerhalb des genannten zweiten Abschnittes bildet,
jede der genannten Speicherzellen mit einer der Wortleitungen (WL1, ...) und mit einer der Bitleitungen (BL3, ...) verbunden ist,
die genannte erste Energiequellenleitung gemeinsam mit den Sourcezonen der N-Kanal-MOSFETs innerhalb der genannten ersten und zweiten Abschnitte verbunden ist,
die genannte zweite Energiequellenleitung gemeinsam mit den ersten und zweiten P-Typ-Zonen der P-Kanal-MOSFETs innerhalb des genannten ersten Abschnittes verbunden ist.

15. Eine integrierte Halbleiterschaltung des Master-Slice-Typs nach Anspruch 1, die als programmierbares Logikarray betriebsfähig ist und umfaßt:
Eingangsleitungen (46, 47);
erste Produkttermleitungen (48, 49);
zweite Produkttermleitungen (53, 54), die mit den genannten ersten Produkttermleitungen verbunden sind;
eine UND-Ebene (44) mit ersten und zweiten Spalten der genannten Basiszellen;
eine ODER-Ebene (45) mit dritten und vierten Spalten der genannten Basiszellen;
bei der jede der genannten Basiszellen in dem zweiten Abschnitt vier N-Kanal-MOSFETs und eine Ausgangsleitung (52) enthält.

## Revendications

1. Circuit intégré semiconducteur du type plaquette mère, comprenant :
une puce semiconductrice (10) ;
des cellules d'entrée-sortie (12) disposées dans une partie périphérique de ladite puce semiconductrice ; et
des cellules de base (20) disposées dans une partie centrale de ladite puce semiconductrice,
chacune desdites cellules de base comportant une première partie (20a) contenant des MOSFET complémentaires sous la forme de paires de premier et deuxième MOSFET à canal N et de premier et deuxième MOSFET à canal P,
les MOSFET à canal P desdites paires comprenant des première et deuxième régions de type P écartées l'une de l'autre dans une première direction, des colonnes, (Y) par une région de canal de type N orientée dans une deuxième direction (X) perpendiculaire à ladite première direction, recouverte de façon isolée par une électrode de grille conductrice (21, 22) ;
les MOSFET à canal N desdites paires comprenant des première et deuxième régions de type N écartées l'une de l'autre dans ladite première direction des colonnes par une région de canal de type P orientée dans ladite deuxième direction, recouverte de façon isolée par une électrode de grille conductrice (21, 22) ;
lesdites premières régions, deuxièmes régions, régions de canal et électrodes de grille des MOSFET à canal N desdites paires étant respectivement placées au voisinage desdites premières régions, deuxièmes régions, régions de canal et électrodes de grille des MOSEFT à canal P desdites paires, dans ladite deuxième direction (X) ;
chacune desdites cellules de base comportant en outre une deuxième partie (20b) contenant des troisième et quatrième MOSFET du type NMOS ;
ladite deuxième partie de chacune desdites cellules de base étant placée au voisinage de ladite première partie de l'une, respective, desdites cellules de base dans ladite deuxième direction (X) ;
ladite deuxième partie de chacune desdites cellules de base contenant au moins un MOSFET qui comprend des première et deuxième régions de type N (28b, 28c) écartées l'une de l'autre par une région de canal de type P, recouverte de façon isolée par une électrode de grille conductrice ;
caractérisé en ce que lesdites première et deuxième régions de type N de ladite deuxième partie sont écartées l'une de l'autre suivant ladite première direction (Y) ; et en ce que l'électrode de grille conductrice dudit MOSFET, dont il y en a au moins un, est décalée suivant ladite première direction des colonnes (Y) par rapport aux grilles conductrices de n'importe lesquels des MOSFET de ladite première partie (20a) contenant des MOSFET complémentaires de façon à permettre à l'une desdites première et deuxième régions de type N (28b et 28c) de ladite deuxième partie d'être connectée à l'une desdites électrodes de grille (22a) de ladite première partie directement par une interconnexion alignée suivant ladite deuxième direction .

2. Circuit intégré semiconducteur du type plaquette mère selon la revendication 1, où l'électrode de grille conductrice dudit MOSFET à canal P et l'électrode de grille conductrice dudit MOSFET à canal N de chacune desdites paires sont formées solidairement par une électrode commune.

3. Circuit intégré semiconducteur du type plaquette mère selon la revendication 1, où lesdites cellules de base forment plusieurs colonnes de cellules de base qui sont disposées suivant une direction (X) perpendiculaires à ladite première direction des colonnes (Y) si bien que lesdites premières parties (20a) desdites colonnes de cellules de base adjacentes sont adjacentes entre elles et lesdites deuxièmes parties (20b) desdites colonnes de cellules de base adjacentes sont adjacentes entre elles.

4. Circuit intégré semiconducteur du type plaquette mère selon la revendication 3, où, entre deux desdites colonnes de cellules de base ayant des premières parties (20a) adjacentes, I'électrode de grille conductrice (25, 26) de ladite deuxième partie (20b) de l'une desdites deux colonnes de cellules de base et l'électrode de grille conductrice (25, 26) de ladite deuxième partie (20b) de l'autre desdites deux colonnes de cellules de base sont décalées suivant ladite première direction des colonnes (Y).

5. Circuit intégré semiconducteur du type plaquette mère selon la revendication 3, où, entre deux desdites colonnes de cellules de base ayant des deuxièmes parties (20b) adjacentes, l'électrode de grille conductrice (25, 26) de ladite deuxième partie (20b) de l'une desdites deux colonnes de cellules de base et l'électrode de grille conductrice (25, 26) de ladite deuxième partie de l'autre desdites deux colonnes de cellules de base sont décalées suivant ladite première direction des colonnes (Y).

6. Circuit intégré semiconducteur du type plaquette mère selon la revendication 1, où, dans ladite première partie, ladite deuxième région dudit premier MOSFET à canal P et ladite première région dudit deuxième MOSFET à canal P sont formées par une région de type P commune (24c), et ladite deuxième région dudit deuxième MOSFET à canal N et ladite première région dudit premier MOSEFT à canal N sont formées par une région de type N commune (23c).

7. Circuit intégré semiconducteur du type plaquette mère selon la revendication 6, où ladite deuxième partie (20b) comporte en outre des cinquième et sixième MOSFET à canal N, lesdits troisième et quatrième MOSFET à canal N étant disposés dans ladite première direction des colonnes et comportant une première région (28a), une deuxième région (28b) et une troisième région (28c) de type N, lesdits cinquième et sixième MOSFET à canal N étant disposés dans ladite première direction des colonnes, écartés desdits troisième et quatrième MOSFET à canal N dans ladite deuxième direction (X), et comportant des quatrième région (27a), cinquième région (27b) et sixième région (27c) de type N, lesdits quatrième et sixième MOSFET à canal N ayant des électrodes de grille conductrices qui sont décalées suivant ladite première direction des colonnes.

8. Circuit intégré semiconducteur du type à plaquette mère selon la revendication 7, où lesdites électrodes de grille conductrices desdits troisième et cinquième MOSFET à canal N sont formées par une électrode solidaire linéaire, et lesdits quatrième et sixième MOSFET à canal N ont des électrodes de grille conductrices qui sont formées par une électrode solidaire.

9. Circuit intégré semiconducteur du type plaquette mère selon la revendication 8, où lesdites cellules de base forment plusieurs colonnes de cellules de base qui sont disposées suivant une direction perpendiculaire à ladite première direction des colonnes, lesdites électrodes de grille conductrices desdits quatrième et sixième MOSFET à canal N de ladite deuxième partie d'une première desdites cellules de base et lesdites électrodes de grille condutrices desdits quatrième et sixième MOSFET à canal N de ladite deuxième partie d'une cellule de base adjacente sont respectivement formées par une électrode commune solidaire, tandis que lesdites électrodes de grille conductrices desdits troisième et cinquième MOSFET à canal N de ladite première desdites cellules de base et lesdites électrodes de grille conductrices desdits troisième et cinquième MOSFET à canal N de ladite cellule de base adjacente sont respectivement formées par une électrode commune solidaire.

10. Circuit intégré semiconducteur du type plaquette mère selon la revendication 7, où la largeur de ladite électrode de grille conductrice suivant ladite première direction de part et d'autre de ladite région de canal le long de ladite deuxième direction est plus grande que celle d'une partie recouvrant ladite région de canal pour chacun desdits MOSFET à canal P et desdits MOSFET à canal N, afin de définir une région de contact d'électrode de grille.

11. Circuit intégré semiconducteur du type plaquette mère selon la revendication 7, où la largeur de ladite électrode de grille conductrice desdits MOSFET à canal P et à canal N se trouvant à l'intérieur de ladite première partie le long de ladite deuxième direction est plus grande que la largeur de ladite électrode de grille conductrices desdits MOSFET se touvant à l'intérieur de ladite deuxième partie le long de ladite deuxième direction.

12. Circuit intégré semiconducteur du type plaquette mère selon la revendication 1, fonctionnant en mémoire vive statique à un seul accès et comprenand :
une ligne de mot (WL1) ;
plusieurs lignes de bit (BL3, XBL3, ...) ;
une première ligne de source d'alimentation électrique destinée à recevoir une première tension (V_{DD}) de source d'alimentation électrique ; et
une deuxième ligne de souce d'alimentation électrique destinée à recevoir une deuxième tension (V_{SS}) de source d'alimentation électrique ;
chacune desdites cellules de base formant une cellule de mémoire qui comporte un circuit de verrouillage formé par deux paires (P1, N1, P2, N2) de MOSFET à canal N et de MOSFET à canal P à l'intérieur de ladite première partie,
chacun desdits MOSFET à canal N qui sont à l'intérieur de ladite deuxième partie formant une porte de transmission qui est connectée à l'une correspondante des lignes de bit (BL3, ...),
chacune desdites portes de transmission étant couplée au circuit de verrouillage d'une unique cellule de mémoire et étant connectée à une ligne de mot commune (WL1),
la région de canal de type N (23c) du MOSFET du canal P étant connectée à la première ligne de de source d'alimentation électrique (V_{DD}),
la région de canal de type P du MOSFET à canal N étant connectée à ladite deuxième ligne de source d'alimentation électrique (V_{SS}).

13. Circuit intégré semiconducteur du type plaquette mère selon la revendication 1, fonctionnant en mémoire vive à double accès et comprenant :
plusieurs lignes de mot (WL1, WL2, ...) ;
plusieurs lignes de bit (BL1, XBL1, BL3, ...) ;
une première ligne de source d'alimentation électrique destinée à recevoir une première tension de source d'alimentation électrique (V_{DD}) ; et
une deuxième ligne de source d'alimentation électrique destinée à recevoir une deuxième tension de source d'alimentation électrique (V_{SS}) ;
chacune desdites cellules de base formant une cellule de mémoire qui comporte un circuit de verrouillage formé par lesdites deux paires (P1, N1, P2, N2) de MOSFET à canal N et de MOSFET à canal P à l'intérieur de ladite première partie,
chacun desdits MOSFET à canal N (N3, N4, N5, N6) qui se trouve à l'intérieur de la deuxième partie formant une porte de transmission qui est couplée à l'une correspondante des lignes de bit (BL1, ...) et à l'une corespondante des lignes de mot (WL1, ...),
la région de canal de type N du MOSFET à canal P étant connectée à ladite première ligne de source d'alimentation électrique,
la région de canal de type P du MOSFET à canal N étant connectée à ladite deuxième ligne de source d'alimentation électrique.

14. Circuit intégré semiconducteur du type plaquette mère selon la revendication 1, fonctionnant en mémoire morte et comprenant :
plusieurs lignes de mot (WL1, WL2, ...) ;
plusieurs lignes de bit (BL3, BL4, ...) ;
une première ligne de source d'alimentation électrique destinée à recevoir une première tension de source d'alimentation électrique ; et
une deuxième ligne de source d'alimentation électrique destinée à recevoir une deuxième tension de source d'alimentation électrique ;
chacune desdites cellules de base formant des cellules de mémoire à l'aide desdits MOSFET à canal N (N10, N11, ...) à l'intérieur de ladite deuxième partie,
chacune desdites cellules de mémoire étant connectées à l'une des lignes de mot (WL1, ...) et à l'une des lignes de bit (... BL3,...),
ladite première ligne de source d'alimentation étant connectée en commun aux régions de source des MOSFET à canal N à l'intérieur desdites première et deuxième parties,
ladite deuxième ligne de source d'alimentation électrique étant connectée en commun aux première et deuxième régions de type P des MOSFET à canal P à l'intérieur de ladite première partie.

15. Circuit intégré semiconducteur du type plaquette mère selon la revendication 1, fonctionnant en matrice logique programmable et comprenant :
des lignes d'entrée (46, 47) ;
des premières lignes de terme produit (48, 49) ;
des deuxièmes lignes de terme produit (53, 54) connectées auxdites premières lignes de terme produit ;
un plan ET (44) comprenant des première et deuxième colonnes desdites cellules de base ;
un plan OU (45) comprenant des troisième et quatrième colonnes desdites cellules de base ;
chacune desdites cellules de base comportant, dans la deuxième partie, quatre MOSFET à canal N,
et une ligne de sortie (52).
